(19) **Europäisches Patentamt**

**European Patent Office**

**Office européen des brevets**

(11) **EP 0 931 212 B1**

(12) **EUROPÄISCHE PATENTSCHRIFT**

(45) Veröffentlichungstag und Bekanntmachung des Hinweises auf die Patenterteilung:
**23.10.2002 Patentblatt 2002/43**

(51) Int Cl.⁷: **F02D 41/34**

(21) Anmeldenummer: **98944999.6**

(22) Anmeldetag: **16.07.1998**

(86) Internationale Anmeldenummer:
**PCT/DE98/01994**

(87) Internationale Veröffentlichungsnummer:
**WO 99/007987 (18.02.1999 Gazette 1999/07)**

(54) **VERFAHREN ZUR ERMITTLUNG VON SEGMENTZEITEN**

METHOD FOR DETERMINING SEGMENT TIMES

PROCEDE DE DETERMINATION DE TEMPS SEGMENTAIRES

(84) Benannte Vertragsstaaten:
**DE FR GB IT SE**

(30) Priorität: **09.08.1997 DE 19734595**

(43) Veröffentlichungstag der Anmeldung:
**28.07.1999 Patentblatt 1999/30**

(73) Patentinhaber: **ROBERT BOSCH GMBH**
**70442 Stuttgart (DE)**

(72) Erfinder:
• **LANG, Tobias**
**D-71672 Marbach (DE)**
• **ZIMMERMANN, Michael**
**D-71723 Grossbottwar (DE)**

(56) Entgegenhaltungen:
**EP-A- 0 750 105       US-A- 5 172 669**
**US-A- 5 325 833       US-A- 5 377 535**
**US-A- 5 554 802**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung geht aus von einem Verfahren zur Ermittlung von Segmentzeiten nach der Gattung des Hauptanspruchs.

Stand der Technik

Für die Regelung von Brennkraftmaschinen wird stets die Winkelstellung der Kurbel- und/oder der Nockenwelle der Brennkraftmaschine benötigt. Aus der Lage dieser Wellen läßt sich ableiten, wann Ansteuersignale für bestimmte Bauelemente abzugeben sind. Beispielsweise ist es von der Lage der Kurbel- und/oder Nockenwelle einer Dieselbrennkraftmaschine abhängig, wann eine Bestromung eines bestimmten Einspritzventils zu erfolgen hat, damit ein möglichst optimaler Verbrennungsvorgang im zugehörigen Zylinder ablaufen kann.

Zur Ermittlung der Winkellage der Kurbel- und/oder der Nockenwelle einer Brennkraftmaschine werden üblicherweise Sensoren eingesetzt, die jeweils ein mit der Kurbel- bzw. Nockenwelle verbundenes Geberrad abtasten. Die beiden Geberräder weisen üblicherweise an ihrem Umfang eine charakteristische Abfolge von Winkelmarken oder Schlitzen auf. Beim Vorbeilaufen dieser Winkelmarken bzw. Schlitze an den feststehenden Sensoren werden in diesen Spannungen induziert, aus deren zeitlichem Verlauf die Oberfläche der betreffenden Geberscheibe abzuleiten ist. Die Sensorspannungen werden zur besseren Auswertbarkeit üblicherweise in Rechtecksignale gewandelt. Aus den zeitlichen Abständen vorgebbarer Signalflanken läßt sich die Drehzahl ermitteln. Die Lage der Signalflanken entspricht jeweils einer bestimmten Winkelstellung der Kurbel- bzw. Nockenwelle.

Bei derzeit in Betrieb befindlichen Dieselbrennkraftmaschinen weist die mit der Kurbelwelle verbundene Geberscheibe bei einer Drehzylinderbrennkraftmaschine 60-3*2 Zähne auf, wobei die Verteilung der Zähne bzw. Winkelmarken so ist, daß drei Lücken gebildet werden und zwischen jeder Lücke jeweils achtzehn Zähne in gleichem Winkelabstand angeordnet sind. Die mit der Nockenwelle verbundene Scheibe weist bei sechs Zylindern sechs Schlitze auf, die voneinander gleichen Winkelabstand aufweisen. Zwischen dem ersten und zweiten Schlitz ist ein siebter Schlitz angeordnet, der als Referenzmarke dient und nur wenig vom ersten Schlitz entfernt ist, beispielsweise 15° NW.

Beim Start der Brennkraftmaschine wird diese mit Hilfe des Starters auf eine Startdrehzahl gebracht. Es rotieren dann die Kurbel- und die Nockenwelle mit relativ konstanter Drehzahl, wobei die Kurbelwelle bekanntermaßen doppelt so schnell rotiert wie die Nockenwelle. Spätestens nach einer Umdrehung der Nockenwelle kann eine Synchronisation erfolgen, da der siebte Zahn als Synchronisationszahn erkannt wird. Ab diesem Zeitpunkt kann im Normalbetrieb mit der korrekten Einspritzung begonnen werden. Die dazu benötigten Ansteuerimpulse werden vom Steuergerät der Brennkraftmaschine, das die Ausgangssignale der Sensoren verarbeitet, abgegeben. Beispielsweise löst das Steuergerät der Brennkraftmaschine die Bestromung der Einspritzventile bzw. den Förderbeginn zum richtigen Zeitpunkt aus und ermöglicht somit eine optimale Regelung der Brennkraftmaschine. Da die Geberscheibe auf der Kurbelwelle eine Vielzahl von Zähnen aufweist, entsteht ein Signal, mit Impulsen, die schnell aufeinanderfolgen, damit kann im Normalfall eine exakte Regelung der Brennkraftmaschine durchgeführt werden. Falls unter ungünstigen Umständen der Kurbelwellensensor ausfällt, sollte allein mit dem Nockenwellensensor ein Notbetrieb möglich sein. Die Aufgabe der vorliegenden Erfindung besteht daher darin, insbesonders im Startfall ohne Kurbelwellensignal einen zuverlässigen Anlauf und Weiterbetrieb der Brennkraftmaschine zu ermöglichen. Es ist jedoch auch Aufgabe der Erfindung, generell eine Möglichkeit anzugeben, mit einem relativ groben Winkelsignal eine zuverlässige Brennkraftmaschinenregelung, insbesonders im Startfall durchzuführen. Gelöst werden diese Aufgaben durch das in Anspruch 1 angegebene Verfahren zur Ermittlung von Segmentzeiten.

Aus der US-PS 5,325,833 ist ein Verfahren zur Regelung einer Brennkraftmaschine bekannt, bei dem die Zündung und/oder Einspritzung von einem Steuergerät geregelt wird. Dieses Steuergerät berechnet die Ansteuersignale für die Zündung und/oder Einspritzung in Abhängigkeit vom Ausgangssignal eines Referenzpositionssensors. Zur Erhöhung der Genauigkeit werden die berechneten Signale mit Hilfe von Korrekturfaktoren an die Erfordernisse angepaßt. Durch Wahl geeigneter Kontrollfaktoren kann insbesonders im Übergangsbereich des Betriebes der Brennkraftmaschine bei sich dann einstellenden positiven oder negativen Beschleunigungen eine besonders einfache und zuverlässige Regelung erzielt werden.

Vorteile der Erfindung

Das erfindungsgemäße Verfahren zur Ermittlung von Segmentzeiten mit den Merkmalen des Anspruchs 1 hat den Vorteil, daß es in Verbindung mit einer herkömmlichen Brennkraftmaschinensteuerung auch bei fehlendem Kurbelwellensensorsignal eine zuverlässige Regelung der Brennkraftmaschine ermöglicht und insbesonders im Startfall eine schnelle und genaue Ermittlung von Ansteuerimpulsen ermöglicht. Bei einfachen Brennkraftmaschinen, die nur eine mit der Nockenwelle in Verbindung stehende Geberscheibe aufweisen, wird ebenfalls eine schnelle und zuverlässige Regelung möglich, dies gilt insbesondere auch im Startfall.

Erzielt werden diese Vorteile, indem die Segmentzeiten, die dem zeitlichen Abstand zwischen zwei voneinander gleichen Winkelabstand aufweisenden Markierungen entsprechend ermittelt werden, wobei im Startfall bei im wesentlichen konstanter Drehzahl zunächst ein erster Beschleunigungsvorgang ausgelöst wird und die zugehörige Segmentzeit $T_k$ und der zugehörige Beschleunigungsquotient $Q_k$ berechnet wird und danach zwei weitere Beschleunigungsvorgänge ausgelöst werden und der erste Beschleunigungsvorgang mittels des ersten gelernten Beschleunigungsquotienten berücksichtigt wird und der zweite Beschleunigungsvorgang aus einer neu ermittelten Segmentzeit bestimmt wird. Danach werden drei aufeinanderfolgende Beschleunigungsvorgänge ausgelöst und die Drehzahländerung der ersten beiden Beschleunigungsvorgänge mit Hilfe der Beschleunigungsquotienten ermittelt, während der dritte Beschleunigungsvorgang wiederum aus der zugehörigen Segmentzeit ermittelt wird. Im Anschluß daran kann eine dynamische Korrektur der zu erwartenden Segmentzeiten erfolgen.

Weitere Vorteile der Erfindung werden durch die in den Unteransprüchen angegebenen Maßnahmen erzielt. Dabei ist besonders vorteilhaft, daß die Beschleunigungsphasen durch Bestromung des bzw. der wählbaren Einspritzventile ausgelöst werden. Bei üblichen Brennkraftmaschinen kann das erfindungsgemäße Verfahren vorteilhafterweise als Notlaufmaßnahme bei defektem Kurbelwelleninkrementsensor durchgeführt werden. In einfachen Systemen, die lediglich einen Geber mit grober Auflösung aufweisen, läßt sich mit dem erfindungsgemäßen Verfahren eine Verbesserung der Genauigkeit bei der Steuerung realisieren, da beschleunigungsbedingte Änderungen der Drehzahl erkannt und kompensiert bzw. gelernt werden können.

Zeichnung

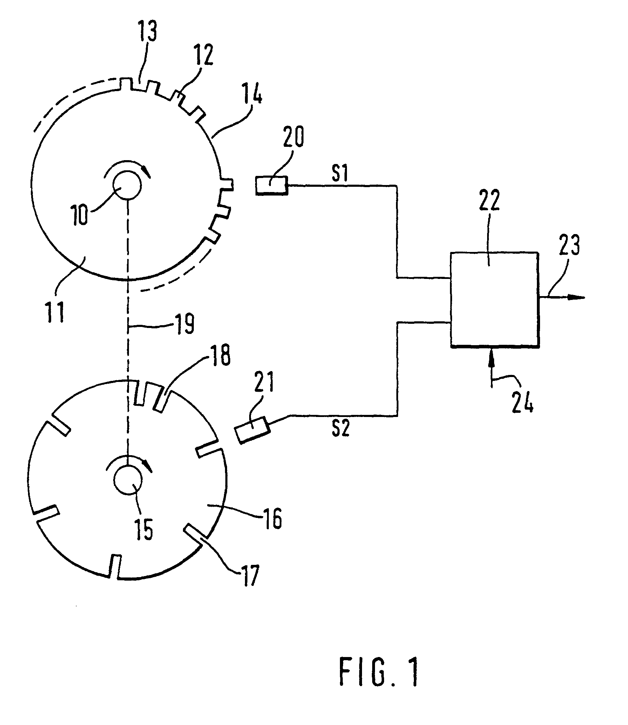

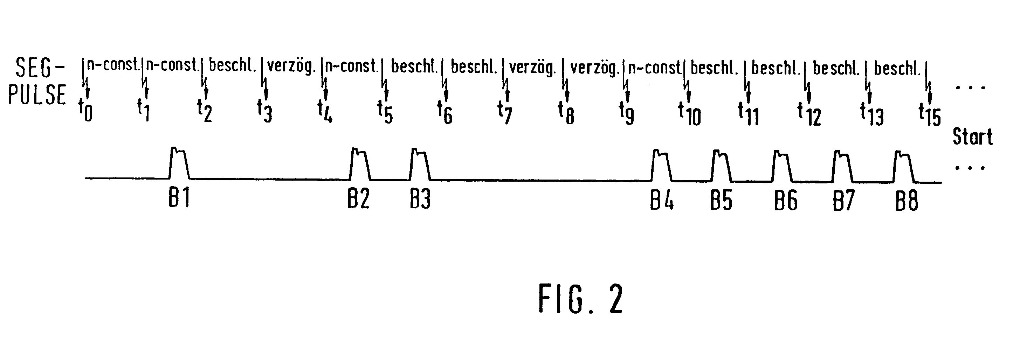

Ein Ausführungsbeispiel der Erfindung ist in der Zeichnung dargestellt und wird in der nachfolgenden Beschreibung näher erläutert. Im einzelnen zeigt Figur 1 die zum Verständnis der Erfindung erforderlichen Bestandteile einer Brennkraftmaschine und Figur 2 zeigt verfahrensgemäße Signale einschließlich der zugehörigen Zeitpunkte.

Beschreibung

Figur 1 zeigt die für das Verständnis der Erfindung wesentlichen Bestandteile einer Brennkraftmaschine. Im einzelnen bezeichnet 10 die Kurbelwelle der Brennkraftmaschine und 11 eine mit der Kurbelwelle 10 verbundene Geberscheibe, die an ihrem Umfang eine Vielzahl von Winkelmarken 12 aufweist, die voneinander einen Winkelabstand 13 aufweisen. Wenigstens einer der Abstände zwischen zwei gleichartigen Winkelmarken ist größer und entspricht beispielsweise zwei fehlenden Winkelmarken.

Die Nockenwelle 15 weist eine Geberscheibe 16 auf, die an ihrem Umfang Schlitze 17 aufweist, die voneinander den gleichen Abstand haben. Zusätzlich ist ein weiterer Schlitz 18 vorhanden, der zur Synchronisation dient und ca. 15° von einem der regulären Schlitze 17 entfernt ist. Für das in Figur 1 dargestellte Ausführungsbeispiel einer Sechszylinderbrennkraftmaschine werden üblicherweise sechs Schlitze 17 und drei Bezugsmarken 14 vorgesehen.

Die Kurbel- und die Nockenwelle sind miteinander über einen Antrieb 19 verbunden. Die Nockenwelle 15 dreht sich üblicherweise halb so schnell wie die Kurbelwelle 10.

Zur Abtastung der beiden Geberscheiben 11, 16 sind feststehende Sensoren 20, 21, beispielsweise Induktivsensoren vorhanden, die ein Ausgangssignal S1, S2 liefern, das einer Signalaufbereitung einen Verlauf aufweist, der der Oberflächenstruktur der beiden Geberscheiben entspricht. Die Auswertung der Signale S1 und S2 erfolgt im Steuergerät 22 der Brennkraftmaschine, das in bekannter Weise wenigstens einen Mikroprozessor sowie geeignete Speichermittel umfaßt. Das Steuergerät 22 berechnet in Abhängigkeit von den von den Sensoren 20, 21 gelieferten Signalen S1, S2 Ansteuerimpulse, beispielsweise zur Bestromung der Einspritzventile oder für den Kraftstoffförderbeginn. Diese Ansteuersignale werden über Verbindungen 23 den jeweiligen Bauteilen zugeführt. Dem Steuergerät 22 können über Verbindungen 24 weitere Informationen hinsichtlich des Betriebszustandes der Brennkraftmaschine oder der Umgebung, in der sich die Brennkraftmaschine befindet, zugeführt werden. Diese zusätzlichen Informationen können bei der Berechnung der Ansteuersignale berücksichtigt werden, sie werden zum Beispiel von geeigneten Sensoren geliefert.

Mit den in Figur 1 dargestellten Bestandteilen einer Brennkraftmaschine läßt sich bei gegebener Funktionsfähigkeit der beiden Sensoren 20 und 21 eine Regelung der Brennkraftmaschine durchführen. Nach dem Start der Brennkraftmaschine werden die Kurbel- bzw. Nockenwelle vom nicht dargestellten Starter zunächst auf eine konstante Drehzahl gebracht. Durch Drehung der Geberscheiben 11, 16 werden in den Sensoren 20, 21 Signale erzeugt, aus deren zeitlicher Abfolge die Drehzahl der Kurbel- bzw. Nockenwelle ermittelbar ist und in Folge der charakteristischen Pulsfolgen läßt sich spätestens nach einer Umdrehung der Nockenwelle, das heißt nach zwei Umdrehungen der Kurbelwelle eine Synchronisation durchführen, so daß im Steuergerät 22 eine eindeutige Zuordnung zwischen der Kurbel- und Nockenwelle bekannt ist. Damit ist auch die Stellung der Zylinder bekannt und die beispielsweise für die Einspritzung oder bei einer fremdgezündeten Brennkraftmaschine für die Zündung erforderlichen Ansteuersignale können abgegeben werden.

Tritt in dem Sensor 20, der das mit der Kurbelwelle verbundene Inkrementrad 11 abtastet, ein Defekt auf, erhält das Steuergerät lediglich Informationen vom Sensor 21. Tritt dieser Defekt bereits im Startfall auf, wird zur Durchführung eines Notlaufes das erfindungsgemäße Verfahren im Steuergerät, das heißt im Mikroprozessor des Steuergerätes 22 durchgeführt.

Erläutert werden soll das erfindungsgemäße Verfahren im folgenden anhand einer adaptiven Segmentzeitbestimmung bei einer Dieselbrennkraftmaschine für den Fall einer Inbetriebnahme der Brennkraftmaschine bei defektem Kurbelwellensensor. In diesem Fall kann ein Notlauf nur anhand der vom Sensor 21 gelieferten Informationen bezüglich der Stellung der Nockenwelle erhalten werden. Die Beschleunigungsvorgänge werden ausgelöst, indem im Start nachdem die Brennkraftmaschine durch den Starter auf im wesentlichen konstante Drehzahl gebracht wurde, eine gezielte Magnetventilansteuerung ausgelöst wird und so ein Verbrennungsvorgang in einem Zylinder ausgelöst wird und die sich nach der ersten Bestromung einstellende Beschleunigung ermittelt wird.

Generell liegt beim Start ohne Inkrementsensorsignal zwar eine grobe Information über die aktuelle Winkelstellung der Nockenwelle und damit auch der Kurbelwelle vor, jedoch sind die exakten Winkelstellungen nicht bekannt, so daß die Magnetventile nach den ersten Zündungen zum falschen Zeitpunkt bestromt werden. Der Grund dafür ist, daß das Segmentsignal pro Nockenwellenumdrehung nur sieben Pulse liefert. Ein Notstart kann dann insbesonders bei tiefen Temperaturen nicht erfolgen.

In Figur 2 ist die erfindungsgemäße Vorgehensweise für einen Notstart ohne Kurbelwellensensorsignal aufgetragen. Mit einem Pfeil sind die vom Nockenwellensensor 21 erzeugten Segmentpulse (SEG-Pulse) bezeichnet. Eine Synchronisation hat stattgefunden, der Synchronisationspuls ist nicht dargesellt. Die Zeitpunkte, zu denen die Segmente auftreten, sind mit $t_x$ bezeichnet, wobei x von 0-15 läuft. Zwischen den Segmentpulsen, die bezogen auf die Nockenwelle 60°NW auseinander liegen, sind Informationen bezüglich der Drehzahl der Nockenwelle eingetragen, wobei die Möglichkeiten Drehzahl n etwa konstant, Beschleunigung und Verzögerung angegeben sind. Im unteren Teil der Figur 2 ist die Bestromung eines bzw. mehrerer Magnetventile angegeben. Diese Bestromung findet jeweils zwischen zwei Segmentpulsen statt. Sie ist zylinderspezifisch korrekt, jedoch zunächst noch ungenau, führt aber dennoch zu einer Einspritzung und damit zu einem Verbrennungsvorgang und zu einer Beschleunigung der Nockenwelle. Anstelle einer Bestromung kann vom Steuergerät auch ein anderes Ansteuersignal über die Verbindung 23 abgegeben werden, das zu einer Verbrennung und damit zu einer Beschleunigung der Nokkenwelle führt.

Gemäß der Darstellung in Figur 2 dreht sich die Nockenwelle zwischen t0 und t1 sowie t1 und t2 etwa mit konstanter Drehzahl. Auf diese Drehzahl wurde sie mit Hilfe des Starters gebracht. Die erste Bestromung B1 verursacht eine Beschleunigung. Zwischen den Segmentpulsen t2 und t3 wird die Nockenwelle beschleunigt. Systembedingt tritt zwischen den Segmentpulsen t3 und t4 wieder eine Verzögerung, das heißt eine Verringerung der Drehzahl auf. Die Zeitspannen zwischen den Zeiten t0 und t1, t1 und t2, usw. werden als Segmentzeit Tk bezeichnet. Diese Zeiten werden vom Steuergerät der Brennkraftmaschine jeweils berechnet, wobei gilt: $T_k = t_k - t_{k-1}$.

Neben der Segmentzeit wird ein Beschleunigungsquotient gebildet, wobei dieser nur in den Zeitintervallen ermittelt wird, in denen tatsächlich eine Beschleunigung aufgetreten ist. Nach der Bestromung B1 wird also der Beschleunigungsquotient $Q_k = T_k/T_{k-1}$ ermittelt, wobei dann gilt: $Q_3 = T_3/T_2$. Die zugehörigen Segmentzeiten sind $T_3 = t_3-t_2$ und $T_2 = t_2-t_1$. Der so berechnete Beschleunigungskoeffizient $Q_3$ wird abgespeichert und bei der nächsten Segmentzeitadaption berücksichtigt.

Sobald vom Steuergerät erkannt wird, daß die Drehzahl wieder konstant ist, wird eine zweite Bestromung B2 eines Einspritzventiles ausgelöst, die zum Einspritzen von Kraftstoff und damit zu einer Verbrennung und damit zur Beschleunigung führt. Nach dem nächsten Segmentpuls wird eine weitere Bestromung B3 vorgenommen, so daß sich nochmals eine Beschleunigung ergibt. Da aus der ersten Ermittlung des Beschleunigungsquotienten $Q_3$ die Beschleunigung für eine Bestromung bekannt ist, läßt sich zum Zeitpunkt $t_5$ berechnen: $T_6 = T_5*Q_3$. Diese Beschleunigung tritt durch die Bestromung B2 auf. Nach einer weiteren Bestromung B3, nach der Kraftstoff in den nächsten Zylinder eingespritzt wird, tritt eine weitere Beschleunigung auf. Der zugehörige Beschleunigungskoeffizient $Q_7$ wird berechnet nach $Q_7 = T_7/T_6$. Die beiden Bestromungen B2 und B3, die zu jeweils zwei Beschleunigungen und zwei Verzögerungen führen, führen letztendlich zu gelernten Segmentzeiten

$$T_{k+x} = T_{k+x-1}*Q_k.$$

Nachdem die gelernte Segmentzeit ermittelbar ist, werden als nächstes drei aufeinanderfolgende Bestromungen B4, B5 und B6 durchgeführt, die beginnend mit dem Zeitpunkt $t_{10}$ zu drei aufeinanderfolgenden Beschleunigungen führen. Der Beschleunigungsverlauf ist nunmehr bekannt. Zum Zeitpunkt $t_{10}$ kann die Segmentzeit berechnet werden nach: $T_{11} = T_{10}*Q_3$ und zum Zeitpunkt $t_{11}$ kann die Segmentzeit $T_{12}$ berechnet werden nach $T_{12} = T_{11}*Q_7$. Nach den durch die Bestromungen B4, B5 und B6 erfolgten Einspritzungen und erfolgreichen Zündungen, die zu drei Beschleunigungen führten, können zum Zeitpunkt $t_{13}$ weitere Beschleunigungen, das heißt Einspritzungen ausgelöst werden, die zu einem Hochlauf der Drehzahl führen, dabei auf eine herkömmliche dynamische Korrektur der Segmentzeit übergegangen werden, mit der der Drehzahlanstieg dann ausgeglichen wird. Diese herkömmliche Segmentzeitkorrektur erfolgt nach der Formel

$$T_{k+1} = T_k*T_k/T_{k-1}.$$

Mit der beschriebenen adaptiven Segmentzeitbestimmung kann somit jeweils eine dynamische Korrektur der zu erwartenden Segmentzeit $T_{k+1}$ erfolgen und die mit der dynamischen Korrektur errechnete falsche Segmentzeiten nach der ersten und zweiten Zündung im Start können ihrerseits korrigiert werden. Deshalb werden die Beschleunigungsquotienten $Q_k$ gelernt und zur Korrektur der Segmentzeit verwendet. Im Startfall wird also die Segmentzeit berechnet nach der Gleichung $T_{k+x} = T_{k+x-1}*Q_k$.

Die Segmentzeiten sowie die Beschleunigungsquotienten und die gelernten Segmentzeiten werden in Speichermitteln des Steuergerätes 22 solange gespeichert wie sie für Berechnungen benötigt werden. Das Ende der adaptiven Segmentzeitkorrektur wird dem Rechner des Steuergerätes beispielsweise durch eine Statusanzeige signalisiert.

Das erfindungsgemäße Verfahren wurde anhand einer Dieselbrennkraftmaschine erläutert. Sie läßt sich grundsätzlich auf andere Brennkraftmaschinen ausdehnen, wobei die Beschleunigungsvorgänge dann durch Betätigung der Einspritzventile und Einspritzung von Kraftstoff in die Zylinder ausgelöst werden. Bei einfacheren Brennkraftmaschinen, die nur eine mit der Nockenwelle in Verbindung stehende Segmentscheibe umfassen, läßt sich das erfindungsgemäße Verfahren nicht nur als Notlaufverfahren sondern als generelles vereinfachtes Verfahren einsetzen. Die bevorzugte Ausgestaltung ist jedoch der Einsatz bei einer modernen Brennkraftmaschine im Fall eines Ausfalls des Kurbelwelleninkrementsensors zur Ermöglichung eines Notlaufes und insbesonders auch eines zuverlässigen Anlaufs der Brennkraftmaschine bei defektem Kurbelwellensensor.

**Patentansprüche**

1. Verfahren zur Ermittlung von Segmentzeiten ($T_k$), die dem zeitlichen Abstand zwischen zwei voneinander gleichen Winkelabstand aufweisenden Markierungen auf einen von einer Brennkraftmaschine antreibbaren rotierenden Körper entsprechen, wobei bei im wesentlichen konstanter Drehzahl des rotierenden Körpers gezielt Beschleunigungsvorgänge ausgelöst werden, indem ein Magnetventil bestromt wird oder ein sonstiges Ansteuersignal vom Steuergerät abgegeben wird, wodurch eine Verbrennung in einem Zylinder ausgelöst wird und zu einer Beschleunigung des rotierenden Körpers führt und Beschleunigungsquotienten $Q_k = T_k/T_{K-1}$ ermittelt werden, die zur Korrektur der nächsten berechneten Segmentzeit mitverwendet werden.

2. Verfahren nach Anspruch 1, **dadurch gekennzeichnet, dass** die Korrektur der Segmentzeit nach folgender Beziehung erfolgt: Segmentzeit $T_{k+x}$=Segmentzeit $T_{k+x-1}$*Beschleunigungsquotient $Q_k$.

3. Verfahren nach Anspruch 1 oder 2, **dadurch gekennzeichnet, daß** ein erster Beschleunigungsvorgang ausgelöst wird, daß die sich einstellende Segmentzeit ermittelt wird, dass der Beschleunigungsquotient ($Q_k$) aus dem Verhältnis der aktuellen Segmentzeit zur vorherigen Segmentzeit ermittelt wird, dass anschließend zwei weitere Beschleunigungen ausgelöst werden und der Beschleunigungsbeitrag der ersten Beschleunigung unter Verwendung des zuvor berechneten Beschleunigungsquotienten ermittelt wird und der zweite Beschleunigungsbeitrag aus dem Verhältnis der aktuellen Segmentzeit und der vorherigen Segmentzeit ermittelt wird.

4. Verfahren nach Anspruch 3, **dadurch gekennzeichnet, dass** nach drei erfolgten Beschleunigungen weitere Beschleunigungen ausgelöst werden und eine dynamische Korrektur der Segmentzeit erfolgt.

5. Verfahren nach einem der vorhergehenden Ansprüche, **dadurch gekennzeichnet, dass** es als Notlauf dient und insbesondere beim Start einer Brennkraftmaschine mit Nockenwellensegmentsensor und Kurbelwelleninkrementsensor eingesetzt wird, wenn der Kurbelwelleninkrementsensor einen Defekt aufweist.

6. Verfahren nach einem der vorhergehenden Ansprüche 1 bis 4, **dadurch gekennzeichnet, dass** es insbesondere beim Start einer Brennkraftmaschine mit Nockenwellensegmentsensor, aber ohne Kurbelwelleninkrementsensor eingesetzt wird.

**Claims**

1. Method for determining segment times ($T_k$) which correspond to the time interval between two marks, having identical angular spacing from one another, on a rotating body which can be driven by an internal combustion engine, acceleration processes being selectively triggered when the rotational speed of the rotating body is essentially constant by a solenoid valve being energized or some other actuation signal being output by the controller, as a result of which combustion is triggered in a cylinder and it leads to an acceleration of the rotating body and acceleration quotients $Q_k = T_k/T_{K-1}$ which are also used for correcting the next calculated segment time are determined.

2. Method according to Claim 1, **characterized in that** the correction of the segment time takes place according to the following relationship:

segment time
$T_{k+x}$ = segment time
$T_{k+x-1}$* acceleration quotient $Q_k$.

3. Method according to Claim 1 or 2, **characterized in that** a first acceleration process is triggered, **in that** the segment time which occurs is determined, **in that** the acceleration quotient ($Q_k$) is determined from the ratio of the current segment time to the previous segment time, **in that** two further acceleration processes are subsequently triggered and the acceleration component of the first acceleration process is determined using the previously calculated acceleration quotient, and the second acceleration component is determined from the ratio of the current segment time to the previous segment time.

4. Method according to Claim 3, **characterized in that**, after three acceleration processes have taken place, further acceleration processes are triggered and a dynamic correction of the segment time takes place.

5. Method according to one of the preceding claims, **characterized in that** it serves as an emergency operating mode and is used in particular when starting an internal combustion engine with camshaft segment sensor and crankshaft increment sensor if the crankshaft increment sensor has a defect.

6. Method according to one of the preceding Claims 1 to 4, **characterized in that** it is used in particular when starting an internal combustion engine with camshaft segment sensor but without a crankshaft increment sensor.

**Revendications**

1. Procédé pour déterminer les segments de temps ($T_k$), qui correspondent à l'intervalle de temps entre deux repères équi-angulaires portés par un organe rotatif entraîné par un moteur à combustion interne, selon lequel, à une vitesse de rotation essentiellement constante de l'organe rotatif, on déclenche de manière intentionnelle des opérations d'accélération en alimentant électriquement une électrovanne ou en fournissant tout autre signal de commande par l'appareil de commande, pour déclencher une combustion dans un cylindre et pour aboutir à une accélération de l'organe rotatif et déterminer des quotients d'accélération $Q_k=T_k/T_{k-1}$, utilisés ensuite pour corriger le segment de temps calculé ensuite.

2. Procédé selon la revendication 1,
**caractérisé en ce que**
la correction du segment de temps se fait selon la relation suivante : segment de temps $T_{k+x}$=Seg-ment de temps $T_{k+x-1}$*quotient d'accélération $Q_k$.

3. Procédé selon la revendication 1 ou 2,
**caractérisé en ce qu'**
on déclenche une première opération d'accélération, on détermine le segment de temps qui s'établit, on détermine le quotient d'accélération $Q_k$ à partir du rapport du segment de temps actuel et du segment de temps précédent, ensuite on déclenche deux autres accélérations et on détermine l'apport d'accélération de la première accélération en utilisant les quotients d'accélération calculés précédemment et on détermine le second apport d'accélération à partir du rapport du segment de temps actuel et du segment de temps précédent.

4. Procédé selon la revendication 3,
**caractérisé en ce qu'**
après trois accélérations effectuées on déclenche d'autres accélérations et on effectue une correction dynamique du segment de temps.

5. Procédé selon l'une des revendications précédentes,
**caractérisé en ce qu'**
il sert de fonctionnement de secours et est utilisé notamment au démarrage d'un moteur à combustion interne avec un capteur de segments d'arbre à cames et un capteur d'incréments de vilebrequin, lorsque le capteur d'incréments de vilebrequin est défectueux.

6. Procédé selon l'une des revendications 1 à 4,
**caractérisé en ce qu'**
il est appliqué notamment au démarrage d'un moteur à combustion interne avec un capteur de segment d'arbre à cames mais sans capteur d'incréments de vilebrequin.

FIG. 1

FIG. 2